(19) Europäisches Patentamt
European Patent Office
Office européen des brevets

(11) **EP 2 034 363 A2**

(12) **EUROPÄISCHE PATENTANMELDUNG**

(43) Veröffentlichungstag:
**11.03.2009 Patentblatt 2009/11**

(51) Int Cl.:
***G03F 7/20*** *(2006.01)*

(21) Anmeldenummer: **08010961.4**

(22) Anmeldetag: **17.06.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(30) Priorität: **22.06.2007 DE 102007029329**

(71) Anmelder: **Carl Zeiss SMT AG**
**73447 Oberkochen (DE)**

(72) Erfinder:
• **Weber, Jochen**
**89520 Heidenheim-Grosskuchen (DE)**
• **Merz, Erich**
**73457 Essingen (DE)**
• **Flügge, Ole**
**73566 Bartholomä (DE)**

• **Berroth, Kai-Uwe**
**89547 Heldenfingen (DE)**
• **Bühler, Cornelia**
**73447 Oberkochen (DE)**
• **Hauf, Markus**
**89075 Ulm (DE)**

(74) Vertreter: **Lorenz, Markus**
**Lorenz & Kollegen**
**Alte Ulmer Strasse 2**
**89522 Heidenheim (DE)**

Bemerkungen:
Die Patentansprüche 16 bis 20 gelten als fallen gelassen, da die entsprechenden Anspruchsgebühren nicht entrichtet wurden (R. 45 (3) EPÜ).

(54) **Optische Baugruppe, Projektionsbelichtungsanlage für die Halbleiterlithogaphie und Projektionsobjektiv**

(57)    Die Erfindung betrifft eine Projektionsbelichtungsanlage (1) für die Halbleiterlithographie mit einer optischen Baugruppe (20) mit einem optischen Element (21) und einem Strukturelement (25), wobei zwischen dem optischen Element (21) und dem Strukturelement (25) ein Spalt (23) verläuft. Dabei ist zur Abdichtung des Spalts (23) ein Dichtelement (22) vorhanden. Zwischen dem Strukturelement (25) bzw. dem optischen Element (21) und dem Dichtelement (22) ist mindestens eine Flüssigkeitsschicht (24) angeordnet, so dass in Richtung der Schichtebene eine relative Verschiebung des Dichtelementes (22) gegenüber dem Strukturelement (25) bzw. dem optischen Element (21) möglich ist.

Fig. 2

EP 2 034 363 A2

**Beschreibung**

Die Erfindung betrifft eine optische Baugruppe sowie eine Projektionsbelichtungsanlage für die Halbleiterlithographie und ein Projektionsobjektiv für die Halbleiterlithographie.

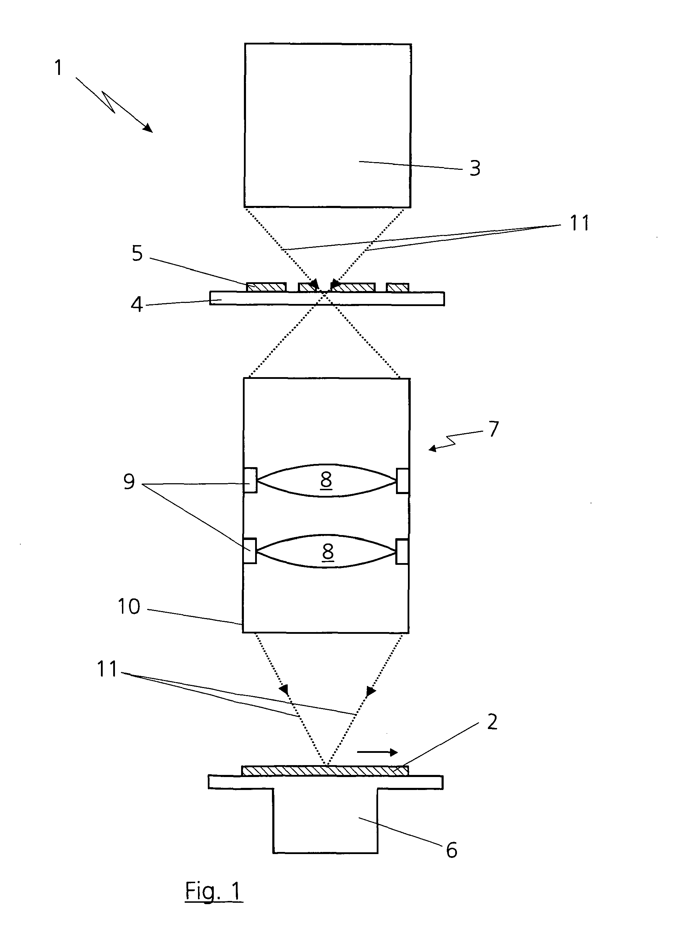

Projektionsbelichtungsanlagen für die Halbleiterlithographie dienen zur Belichtung von Strukturen auf ein mit photosensitiven Materialien beschichtetes Substrat, welches im allgemeinen überwiegend aus Silizium besteht und als Wafer bezeichnet wird, zur Herstellung von Halbleiterbauelementen, wie z. B. Computerchips. In Figur 1 ist eine Projektionsbelichtungsanlage nach dem Stand der Technik dargestellt.

Die Projektionsbelichtungsanlage 1 besteht dabei im wesentlichen aus einer Beleuchtungseinrichtung 3, einer Einrichtung 4 zur Aufnahme und exakten Positionierung einer mit einer Struktur versehenen Maske, einem sogenannten Reticle 5, durch welches die späteren Strukturen auf dem Wafer 2 bestimmt werden, einer Einrichtung 6 zur Halterung, Bewegung und exakten Positionierung eben dieses Wafers 2 und einer Abbildungseinrichtung, nämlich einem Projektionsobjektiv 7, mit mehreren optischen Elementen 8, die über Fassungen 9 in einem Objektivgehäuse 10 des Projektionsobjektives 7 gelagert sind.

Das grundsätzliche Funktionsprinzip sieht dabei vor, dass die in das Reticle 5 eingebrachten Strukturen auf den Wafer 2 abgebildet werden.

Nach einer erfolgten Belichtung wird der Wafer 2 in Pfeilrichtung weiterbewegt, sodass auf demselben Wafer 2 eine Vielzahl von einzelnen Feldern, jeweils mit der durch das Reticle 5 vorgegebenen Struktur, belichtet wird. Aufgrund der schrittweisen Vorschubbewegung des Wafers 2 in der Projektionsbelichtungsanlage 1 wird diese häufig auch als Stepper bezeichnet. Zur Verbesserung der Prozessparameter wird dabei in den Step-und-Scan-Systemen das Reticle 5 durch eine schlitzförmige Blende kontinuierlich abgescannt.

Die Beleuchtungseinrichtung 3 stellt einen für die Abbildung des Reticles 5 auf dem Wafer 2 benötigten Projektionsstrahl 11, beispielsweise Licht oder allgemein elektromagnetische Strahlung, bereit. Als Quelle für diese Strahlung kann ein Laser oder dergleichen Verwendung finden. Die Strahlung wird in der Beleuchtungseinrichtung 3 über optische Elemente so geformt, dass der Projektionsstrahl 11 beim Auftreffen auf das Reticle 5 die gewünschten Eigenschaften hinsichtlich Durchmesser, Polarisation, Form der Wellenfront und dergleichen aufweist.

Über den Projektionsstrahl 11 wird ein Bild des Reticles 5 erzeugt und von dem Projektionsobjektiv 7 entsprechend auf den Wafer 2 übertragen, wie bereits vorstehend erläutert wurde. Das Projektionsobjektiv 7 weist eine Vielzahl von einzelnen refraktiven, diffraktiven und/oder reflexiven optischen Elementen 8, wie z. B. Linsen, Spiegeln, Prismen, Abschlussplatten und dergleichen auf.

Die Bereiche zwischen den einzelnen optischen Elementen 8 der Projektionsbelichtungsanlage 1 müssen dabei für bestimmte Anwendungen gegeneinander bzw. gegenüber der Umgebung abgedichtet werden. Dies erfolgt in der Regel durch das Anbringen einer Dichtung zwischen der Fassung 9 und dem optischen Element 8. Derartige Dichtungen werden in der Regel als dünne, strukturierte Dichtelemente ausgeführt, die fest an den beiden Komponenten optisches Element 8 und Fassung 9 angebracht sind. Aufgrund der Steifigkeit der Dichtelemente ergeben sich jedoch Kräfte auf die optischen Elemente 8, die zu einer unerwünschten Verformung der optischen Elemente 8 und damit zur Entstehung von Bildfehlern führen.

Diese geschilderte Problematik wird dadurch weiter verschärft, dass zunehmend optische Elemente 8 eingesetzt werden, die mittels eines Manipulators relativ zur umgebenden Struktur, wie beispielsweise einem Fassungsteil, bewegt werden. In diesem Fall sind die Auslenkungen der Bewegungen der optischen Elemente 8 in der Regel so groß, dass eine konventionelle Dichtung nicht bzw. nur noch sehr schwer möglich ist. In der Regel wird in diesen Fällen eine sogenannte Leaky-Seal-Dichtung bzw. Spalt- oder Gasdichtung verwendet, bei der ein gewisser Gasstrom zwischen dem optischen Element 8 und der umgebenden Struktur in Kauf genommen wird. Derartige Dichtkonzepte sind beispielsweise in der internationalen Patentanmeldung WO 2006/069755 A2, die auf die Anmelderin zurückgeht, offenbart.

Aufgabe der vorliegenden Erfindung ist es, eine optische Baugruppe, ein Projektionsobjektiv für die Halbleiterlithographie sowie eine Projektionsbelichtungsanlage für die Halbleiterlithographie anzugeben, bei der bzw. dem eine optimale Abdichtung von optischen Elementen gegenüber umgebenden Strukturelementen gewährleistet ist, ohne dass aufgrund der verwendeten Dichtelemente zusätzliche, störende Kräfte von den umgebenden Strukturelementen auf die optischen Elemente übertragen werden.

Diese Aufgabe wird gelöst durch die Vorrichtung mit den in Anspruch 1 angegebenen Merkmalen. Die Unteransprüche betreffen vorteilhafte Ausführungsformen und Weiterbildungen der Erfindung.

Die erfindungsgemäße optische Baugruppe zeigt ein optisches Element und ein Strukturelement. Dabei kann es sich bei dem optischen Element beispielsweise um eine Linse oder auch ein anderes refraktives bzw. diffraktives Element und bei dem Strukturelement um ein Fassungsteil, insbesondere in einem Projektionsobjektiv für die Halbleiterlithographie handeln.

Zwischen dem optischen Element und dem Strukturelement verläuft ein Spalt, so dass das optische Element mit dem Strukturelement nur an einzelnen Lagerpunkten in Verbindung steht. Der Spalt kann eine Dicke im Bereich von ca. 0,1 mm bis 0,5 mm, vorzugsweise im Bereich von 0,2 mm bis 0,4 mm aufweisen; er wird dadurch abgedichtet, dass ein Dichtelement vorhanden ist und dass zwischen dem Dichtelement und dem Strukturelement bzw. dem optischen Element eine Flüssigkeitsschicht verläuft, entlang deren Schichtebene eine relative Verschiebung des Dichtelementes gegenüber dem Strukturelement bzw. dem optischen Element möglich ist.

Die Flüssigkeitsschicht hat dabei die Wirkung, dass einerseits der Bereich zwischen dem Dichtelement und dem Strukturelement bzw. dem optischen Element abgedichtet wird und andererseits eine Bewegung des Dichtelements relativ zu dem Strukturelement bzw. dem optischen Element parallel zur Schichtebene möglich ist. Auf diese Weise wird die Dichtwirkung gegenüber dem aus dem Stand der Technik bekannten "Leaky Seal" erheblich verbessert, da der Bereich des Spaltes vollständig durch das Dichtelement abgedichtet wird. Ferner wird eine gute mechanische Entkopplung des Dichtelements von dem optischen Element bzw. dem Strukturelement erreicht, die sowohl langsame Relativbewegungen der beteiligten Partner zueinander, die beispielsweise aus einer allmählichen Temperaturänderung herrühren können, als auch dynamische Bewegungen, beispielsweise aus Vibrationen, wirkungsvoll kompensiert.

Die Dicke der Flüssigkeitsschicht hängt dabei insbesondere von der Oberflächenspannung der verwendeten Flüssigkeit sowie von der durch die Flüssigkeitsschicht bedeckten Fläche ab, was die Möglichkeit eröffnet, durch die Wahl der genannten Parameter bei der Konstruktion der erfindungsgemäßen optischen Baugruppe die Dicke der Flüssigkeitsschicht definiert einzustellen.

Die Oberflächenspannung der für die Flüssigkeitsschicht verwendeten Flüssigkeit und damit die Kapillarkräfte im Bereich zwischen Dichtelement und optischen Element bzw. Strukturelement haben die Wirkung, dass einerseits das Dichtelement selbst in Richtung der optischen Achse der optischen Baugruppe in Position gehalten wird und andererseits auch die Flüssigkeitsschicht selbst im gewünschten Bereich gehalten wird.

Die optische Achse der optischen Baugruppe kann hierfür insbesondere durch die optische Achse des Projektionsobjektivs vorgegeben sein.

Als vorteilhafte Dimensionen der Flüssigkeitsschicht hat sich eine Dicke im Bereich von 1 μm bis 10 μm sowie eine laterale Ausdehnung entlang der Schichtebene, insbesondere senkrecht zur optischen Achse im Bereich von ca. 2 mm bis ca. 8 mm erwiesen.

Eine sehr effektive mechanische Entkopplung kann dadurch erreicht werden, dass sowohl zwischen dem Strukturelement und dem Dichtelement als auch zwischen dem optischen Element und dem Dichtelement die Flüssigkeitsschicht angeordnet ist; dabei können die Flüssigkeitsschichten insbesondere als im Wesentlichen ebene Schichten ausgebildet sein und die Flüssigkeitsschicht zwischen dem Strukturelement und dem Dichtelement kann beispielsweise um ca. 0° bis 20° von der Richtung der optischen Achse der optischen Baugruppe abweichen, während die Flüssigkeitsschicht zwischen dem optischen Element und dem Dichtelement um ca.

70° bis 110° von der Richtung der optischen Achse der optischen Baugruppe abweichen kann. Diese geometrische Anordnung der beteiligten Flüssigkeitsschichten gewährleistet, dass sowohl in Richtung der optischen Achse als auch senkrecht zur Richtung der optischen Achse eine wirksame mechanische Entkopplung des Dichtelementes von dem optischen Element und auch von dem Strukturelement erreicht wird.

Im Falle von gewölbten optischen Elementen kann die Flüssigkeitsschicht selbstverständlich ebenfalls als gewölbte Schicht ausgebildet sein; in diesem Fall ist es vorteilhaft, wenn das Dichtelement ebenfalls als gewölbtes Blättchen mit einer Dicke im Bereich von ca. 5 μm bis 15 μm ausgebildet ist.

Eine vorteilhafte Wahl für das Material des Dichtelementes stellt Edelstahl dar; Edelstahl hat die Eigenschaft, ultraviolette Strahlung nicht passieren zu lassen, so dass die Flüssigkeitsschicht durch den Edelstahl wirksam von beispielsweise ultravioletter optischer Nutzstrahlung des übergeordneten Systems, in dem die erfindungsgemäße Baugruppe eingesetzt wird, abgeschirmt wird. Dies ist insbesondere in den Fällen, in denen die erfindungsgemäße optische Baugruppe als Teil eines Projektionsobjektives für die Halbleiterlithographie eingesetzt wird, vorteilhaft, da in diesen Anwendungen regelmäßig als optische Nutzstrahlung ultraviolette Strahlung kurzer Wellenlänge zur Anwendung kommt. Durch die genannte Maßnahme wird verhindert, dass die energiereiche ultraviolette Strahlung die für die Flüssigkeitsschicht verwendete Flüssigkeit zersetzt und somit die Wirksamkeit der erfindungsgemäßen optischen Baugruppe beeinträchtigt.

Alternativ kann für das Dichtelement auch Quarz verwendet werden, was den Vorteil hat, dass insbesondere bei der Verwendung von optischen Elementen aus Quarz die Flüssigkeitsschicht beidseitig von Elementen aus dem selben Material begrenzt wird, wodurch sich auf einfache Weise definierte Bedingungen für die erfindungsgemäße Dichtung einstellen lassen.

Eine verbesserte mechanische Entkopplung von optischem Element und Strukturelement in Richtung der optischen Achse kann auch dadurch erreicht werden, dass das Dichtelement im Bereich des Spaltes eine wellenförmige Struktur aufweist, dabei verläuft die Wellenstruktur in vorteilhafter Weise in Richtung des Spaltes. Durch die beschriebene Ausführung des Dichtelementes wird eine Verringerung der Steifigkeit des Dichtelements in Richtung der optischen Achse erreicht, so dass die aufgrund von Relativbewegungen des optischen Elementes zum Strukturelement in Richtung der optischen Achse eingetragenen Kräfte minimal gehalten werden.

Zur Befestigung des Dichtelements an dem Strukturelement stehen verschiedene Verbindungstechniken zur Wahl, wie z. B. Kleben, Vulkanisieren, Klemmen usw..

In den Fällen, in denen das optische Element eine planparallele Platte ist, wird schon allein durch die Geometrie des optischen Elementes sichergestellt, dass aufgrund von Relativbewegungen des optischen Elementes zum Strukturelement vertikal zur optischen Achse keine Kräfte in Richtung der optischen Achse eingetragen werden. In den Fällen, in denen das optische Element eine gewölbte Oberfläche zeigt, also beispielsweise als Linse ausgebildet ist, kann ein ähnlicher Effekt dadurch erreicht werden, dass der Linsenrand in dem Bereich, in dem er von dem Dichtelement bedeckt ist, im Wesentlichen plan ausgebildet ist.

Um die Funktionalität der erfindungsgemäßen optischen Baugruppe aufrecht zu erhalten, ist es vorteilhaft, einem Kriechen der für die Flüssigkeitsschicht verwendeten Flüssigkeit in Richtung des optisch aktiven Bereichs des optischen Elementes entgegen zu wirken. Unter optisch aktivem Bereich wird dabei der Bereich des optischen Elementes verstanden, der bei einem bestimmungsgemäßen Gebrauch der optischen Baugruppe von der optischen Nutzstrahlung durchtreten wird. Insbesondere kann einem Kriechen der Flüssigkeit in Richtung des optisch aktiven Bereichs dadurch entgegengewirkt werden, dass im an das Dichtelement angrenzenden Bereich des optischen Elementes eine umlaufende Nut und/oder ein umlaufender Wall angeordnet ist, durch die bzw. den eine weitere Ausbreitung der Flüssigkeitsschicht in Richtung des optisch aktiven Bereichs verhindert wird.

Die Lebensdauer der erfindungsgemäßen optischen Baugruppe kann dadurch erhöht werden, dass im Bereich der Flüssigkeitsschicht in dem optischen Element bzw. in dem Strukturelement mindestens ein Hohlraum zur Aufnahme eines Flüssigkeitsvorrates vorhanden ist. Im Falle des Ausgasens der Flüssigkeitsschicht oder eines sonstigen Flüssigkeitsverlusts wird durch die Kapillarkräfte Reserveflüssigkeit aus dem genannten Hohlraum in den Bereich der Flüssigkeitsschicht nachgezogen, so dass ein Trockenlaufen des Dichtelementes auf dem optischen Element bzw. dem Strukturelement unterbunden bzw. verzögert wird.

Eine vorteilhafte Variante zur Lagerung des optischen Elementes besteht in einer sog. isostatischen Lagerung. Bei einer derartigen Lagerung handelt es sich um eine punktuelle Lagerung des optischen Elementes an drei Lagerstellen, durch die keine Momente in das optische Element eingeleitet werden, so dass das Auftreten von Spannungen in dem optischen Element weitgehend vermieden wird.

Die Erfindung kann in vorteilhafter Weise auch zur Nachrüstung bereits vorhandener konventioneller Leaky-Seal-Dichtungen verwendet werden. In diesem Fall wird die nachzurüstende Leaky-Seal-Dichtung noch um das erfindungsgemäße Dichtelement und die Flüssigkeitsschicht ergänzt. Mit anderen Worten sind in dieser Variante der Erfindung das optische Element und/oder das Strukturelement und/oder der Spalt in der Weise ausgebildet, dass bei Abwesenheit des Dichtelementes eine Leaky-Seal-Dichtung realisiert ist.

Eine vorteilhafte Wahl für die verschiedenen Parameter der Flüssigkeitsschicht besteht dabei darin, dass die kinematische Viskosität ν im Bereich von 300 - 3000 mm$^2$/s liegt.

Die erfindungsgemäße optische Baugruppe kann in vorteilhafter Weise in einem Projektionsobjektiv einer Projektionsbelichtungsanlage für die Halbleiterlithographie eingesetzt werden. Zur Abdichtung eines Projektionsobjektivs gegen die Umgebung kann dabei die erfindungsgemäße optische Baugruppe das erste bzw. das letzte optische Element der Projektionsbelichtungsanlage als optisches Element enthalten.

Es ist ebenso denkbar, die erfindungsgemäße optische Baugruppe in einem Projektionsobjektiv für die Mikrolithographie mit einer gegebenen Feldgröße und Apertur beispielsweise als Korrekturelement im Bereich einer Pupillenebene, insbesondere in einem Abstand von dieser anzuordnen, der einem Subaperturverhältnis von größer als 0,7, bevorzugt größer als 0,8, entspricht. Für ein optisches System, welches ein Objektfeld mit einer maximalen Objekthöhe unter einer gegebenen Apertur auf ein Bildfeld abbildet, definiert man das Subaperturverhältnis durch

$$\left|R-H\right|/\left(\left|R-H\right|+\left|H\right|\right),$$

wobei, ausgehend von einem Objektpunkt maximaler Objekthöhe, R die Randstrahlhöhe und H die Hauptstrahlhöhe ist, und diese Strahlhöhen in einer gegebenen Ebene, welche parallel zu einer Pupillenebene des optischen Systems ist, gemessen werden.

Das Subaperturverhältnis nimmt Werte zwischen 0 und 1 an. Das Subaperturverhältnis hat den Wert 1 in jeder Pupillenebene des optischen Systems und den Wert 0 in jeder Feldebene des optischen Systems.

Diese Definition findet insbesondere für die Projektionsoptiken für die Halbleiterlithographie Anwendung, denn diese sind für eine, von der Projektionsoptik abhängige, maximale Objekthöhe und maximale Apertur korrigiert. Hierdurch sind eine maximale Objekthöhe und eine Apertur solchen Projektionsoptiken als optischen Systemen in natürlicher Weise zugeordnet.

Die genannte Position im Objektiv ist deswegen vorteilhaft, weil in der Regel die größten Beiträge zu den Fehlern einer Projektionsbelichtungsanlage von sog. Pupillenfehlern stammen, die im Bereich der Pupille am effektivsten korrigiert werden können. Darüber hinaus ist der Bereich der Pupillenebene ein besonders günstiger Ort, um eine Bildfehlerkorrektur mittels optischer Korrekturelemente vorzunehmen, da durch Maßnahmen in der Pupillenebene gleichartige Modifikationen der Abbildung in jedem Ort einer Bildebene erreicht werden können.

Nachfolgend werden Ausführungsbeispiele und Variationen der Erfindung anhand der Figuren näher erläutert.

Fig. 1 Eine Projektionsbelichtungsanlage nach dem Stand der Technik;

Fig. 2    eine erfindungsgemäße optische Baugruppe in einer ersten Ausführungsform;

Fig. 3    eine weitere Ausführungsform der erfindungsgemäßen optischen Baugruppe, bei der das optische Element als planparallele Platte ausgebildet ist;

Fig. 4    eine weitere Ausführungsform der erfindungsgemäßen optischen Baugruppe; und

Fig. 5    eine zusätzliche Variante der erfindungsgemäßen Baugruppe; und

Fig. 6    eine Projektionsbelichtungsanlage für die Halbleiterlithographie, die mehrere der erfindungsgemäßen optischen Baugruppen enthält.

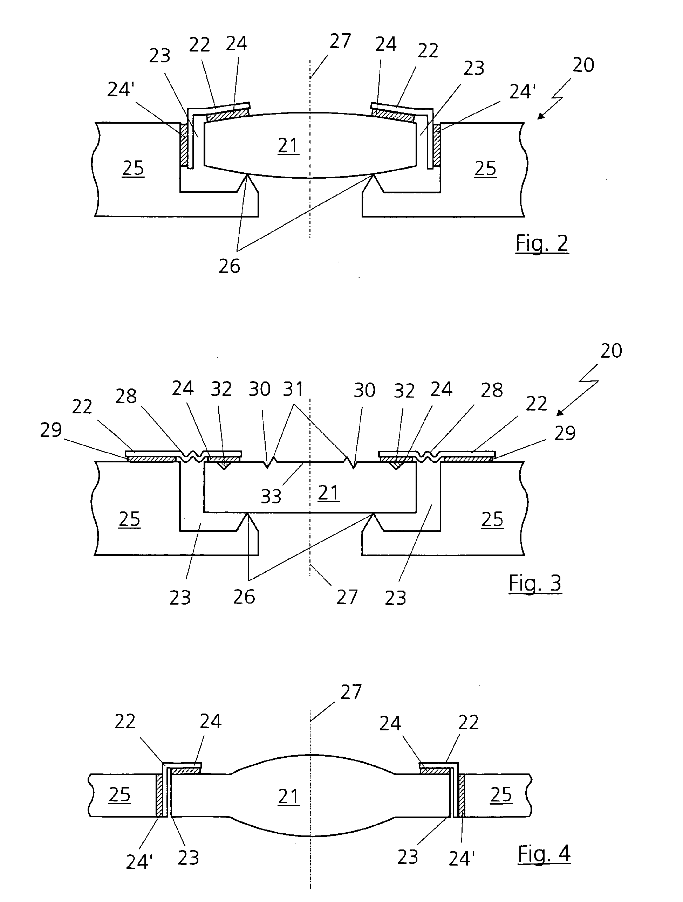

Figur 2 zeigt in einer Schnittdarstellung eine erste Ausführungsform einer erfindungsgemäßen optischen Baugruppe 20, bei der das optische Element 21 als Linse ausgebildet ist. Die Linse 21 ruht dabei innerhalb des als Fassung ausgebildeten Strukturelementes 25 auf drei punktförmigen Lagerstellen 26, von denen zwei in der Figur 2 dargestellt sind. In dem Spalt 23 zwischen dem optischen Element 21 und dem Strukturelement 25 ist das Dichtelement 22 angeordnet. Aufgrund der Wölbung der Linsenoberfläche ist auch das Dichtelement 22 in dem Bereich, an dem es mittels der Flüssigkeitsschicht 24 auf der gewölbten Linsenoberfläche anliegt, der Wölbung der Linsenoberfläche angepasst. Die Flüssigkeitsschicht 24 gewährleistet eine Beweglichkeit des Dichtelements 22 vertikal zur optischen Achse 27, ohne dass vertikal zur Richtung der optischen Achse 27 Kräfte in das optische Element 21 eingetragen werden. Darüber hinaus ist das Dichtelement 22 nicht fest mit dem Strukturelement 25 verbunden, sondern steht ebenfalls über die Flüssigkeitsschicht 24' mit dem Strukturelement 25 in Verbindung. Auf diese Weise wird gewährleistet, dass es keinerlei starre Verbindung des Dichtelements 22 zum Strukturelement 25 oder auch zum optischen Element 21 gibt. Diese Maßnahme gewährleistet, dass das optische Element 21 in bestmöglicher Weise gegenüber Positionsänderungen der Umgebung, beispielsweise des Strukturelementes 25, die beispielsweise auf eine Temperaturänderung zurückgehen können, mechanisch entkoppelt ist. In vorteilhafter Weise wird für die Flüssigkeitsschicht ein Öl hoher Oberflächenspannung, aber geringer Viskosität und hohen Dampfdrucks verwendet, um gute Haftung an den Komponenten bei minimalen Scherkräften und minimaler Kontamination des Inneren eines übergeordneten optischen Systems zu erreichen.

Die Dicke der Flüssigkeitsschicht 24 bzw. 24' kann dabei ca. 1 µm bis ca. 10 µm betragen; in ihrer lateralen Ausdehnung kann sie einen Bereich von ca. 2 mm bis 8 mm beanspruchen. Im vorliegenden Fall ist das Dichtelement 22 als Edelstahlelement mit einer Dicke von ca. 5 µm bis 15 µm ausgebildet; auch die Verwendung von anderen Materialien wie bspw. von Quarz ist denkbar.

Figur 3 zeigt eine Variante der Erfindung, bei der das optische Element 21 als planparallele Platte ausgebildet ist, die in ähnlicher Weise wie in dem in Figur 2 gezeigten Ausführungsbeispiel in einem als Fassung ausgebildeten Strukturelement 25 mittels dreier Lagerpunkte 26 gelagert ist, von denen zwei in Figur 3 dargestellt sind. In dem in Figur 3 dargestellten Ausführungsbeispiel ist das Dichtelement 22 mit dem Strukturelement 25 über die Vulkanisierungsschicht 29 fest verbunden. Die mechanische Entkopplung des optischen Elements 21 von dem Strukturelement 25 in Richtung der optischen Achse 27 wird in dem in Figur 3 dargestellten Beispiel dadurch erreicht, dass das Dichtelement 22 im Bereich des Spalts 23 die wellenförmige Struktur 28 aufweist, die ein Durchbiegen bzw. Abknicken des Dichtelements 22 im Bereich des Spalts 23 erleichtert und auf diese Weise die Entkopplung in Richtung der optischen Achse 27 gewährleistet. Darüber hinaus ist in dem Bereich des optischen Elements 21, der von der Flüssigkeitsschicht 24 bedeckt ist, der Hohlraum 32 vorgesehen, der mit der Flüssigkeit angefüllt ist, durch die die Flüssigkeitsschicht 24 gebildet wird. Der Hohlraum 32 hat die Funktion als Flüssigkeitsreservoir für die Flüssigkeitsschicht 24 zu dienen; d. h., wenn beispielsweise durch Ausgasen oder Kriechen Flüssigkeit aus dem Bereich der Flüssigkeitsschicht 24 verloren geht, kann aufgrund der Kapillarkräfte aus dem Hohlraum 32 Reserveflüssigkeit nachgezogen werden, so dass sich auf diese Weise die Lebensdauer der erfindungsgemäßen optischen Baugruppe 20 deutlich erhöht. Darüber hinaus sind in dem Bereich zwischen der Flüssigkeitsschicht 24 und dem optisch aktiven Bereich 33 des optischen Elements 21 die Nut 30 und der Wall 31 angeordnet, die ein Kriechen von Flüssigkeit aus der Flüssigkeitsschicht 24 in Richtung des optisch aktiven Bereichs 33 des optischen Elements unterbinden und auf diese Weise die Funktionsfähigkeit der erfindungsgemäßen optischen Baugruppe 20 sicherstellen.

Figur 4 zeigt eine weitere Ausführungsform der erfindungsgemäßen optischen Baugruppe 20, bei der das optische Element 21 zwar gewölbt, jedoch mit einem abgeflachten Rand ausgebildet ist, so dass verhindert wird, dass aufgrund von Kräften vertikal zur optischen Achse 27 Querkräfte in Richtung der optischen Achse 27 aufgrund der Wölbung des optischen Elements 21 eingetragen werden.

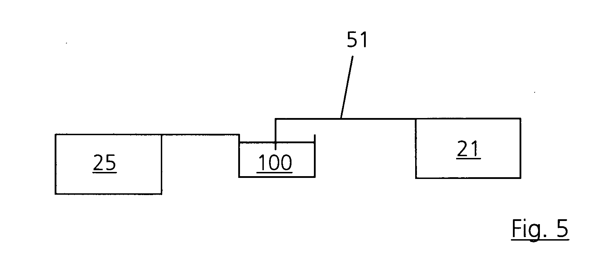

Eine Dichtung zwischen dem optischen Element 21 und einem Strukturelement 25 kann auch nach dem in Figur 5 dargestellten Siphon-Prinzip erfolgen, indem zum Beispiel ein Flüssigkeitsreservoir 100 am Strukturelement 25 angebracht ist, in welches eine an dem optischen Element 21 angebrachte Dichtlippe 51 eingreift, um eine Dichtwirkung herzustellen. Selbstverständlich kann das optische Element 21 und das Strukturelement 25 auch bezüglich der Dichtlippe 51 und des Reservoirs 100 vertauscht sein.

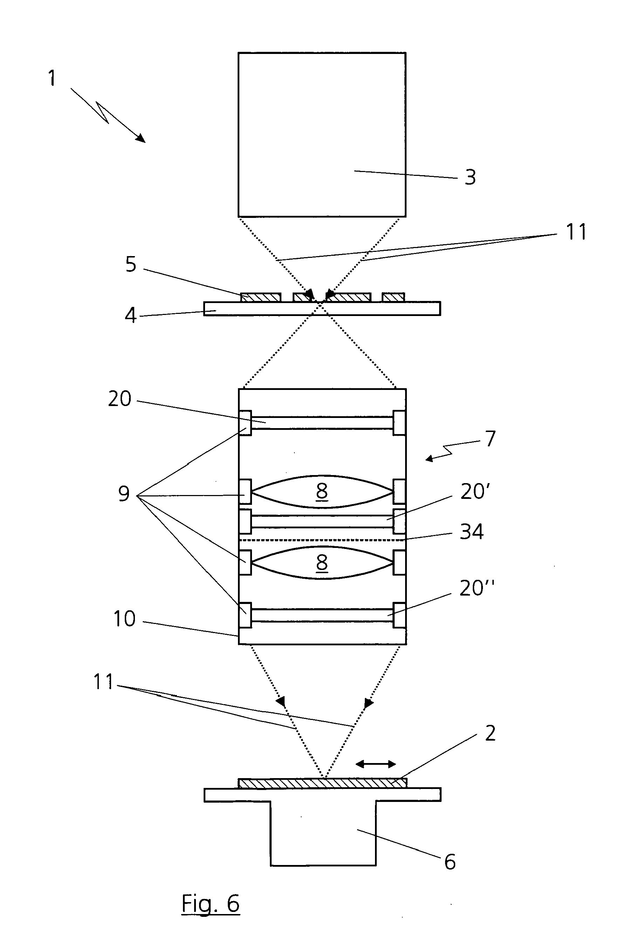

Figur 6 zeigt eine Projektionsbelichtungsanlage für die Halbleiterlithographie 1, in der die erfindungsgemäßen optischen Baugruppen 20, 20' und 20" in der Weise angeordnet sind, dass sie sich entweder im Bereich einer Pupillenebene 34 befinden bzw. das erste und/oder letzte optische Element des Projektionsobjektives enthalten.

**Patentansprüche**

1. Projektionsbelichtungsanlage (1) für die Halbleiterlithographie mit einer optischen Baugruppe (20) mit einem optischen Element (21) und einem Strukturelement (25), wobei zwischen dem optischen Element (21) und dem Strukturelement (25) ein Spalt (23) verläuft, **dadurch gekennzeichnet, dass** zur Abdichtung des Spalts (23) ein Dichtelement (22) vorhanden ist und zwischen dem Strukturelement (25) bzw. dem optischen Element (21) und dem Dichtelement (22) mindestens eine Flüssigkeitsschicht (24) angeordnet ist und in Richtung der Schichtebene eine relative Verschiebung des Dichtelementes (22) gegenüber dem Strukturelement (25) bzw. dem optischen Element (21) möglich ist.

2. Projektionsbelichtungsanlage (1) nach Anspruch 1, **dadurch gekennzeichnet, dass** die Flüssigkeitsschicht (24) eine Dicke im Bereich von 1$\mu$m -10$\mu$m zeigt.

3. Projektionsbelichtungsanlage (1) nach einem der vorangehenden Ansprüche, **dadurch gekennzeichnet, dass** die Flüssigkeitsschicht (24) eine laterale Ausdehnung im Bereich von ca. 2mm-8mm zeigt.

4. Projektionsbelichtungsanlage (1) nach einem der vorangehenden Ansprüche, **dadurch gekennzeichnet, dass** sowohl zwischen dem Strukturelement (25) und dem Dichtelement (22) als auch zwischen dem optischen Element (21) und dem Dichtelement (22) eine Flüssigkeitsschicht (24, 24') angeordnet ist.

5. Projektionsbelichtungsanlage (1) nach Anspruch 4, **dadurch gekennzeichnet, dass** die Flüssigkeitsschichten (24, 24') als im Wesentlichen ebene Schichten ausgebildet sind und die Flüssigkeitsschicht (24') zwischen dem Strukturelement (25) und dem Dichtelement (22) ca. um 0°-20° von der Richtung der optischen Achse (27) der optischen Baugruppe abweicht, während die Flüssigkeitsschicht (24) zwischen dem optischen Element (21) und dem Dichtelement (24) ca. um 70°-110° von der Richtung der optischen Achse (27) der optischen Baugruppe (24) abweicht.

6. Projektionsbelichtungsanlage (1) nach einem der vorangehenden Ansprüche 1-4, **dadurch gekennzeichnet, dass** die mindestens eine Flüssigkeitsschicht (24) als gewölbte Schicht ausgebildet ist.

7. Projektionsbelichtungsanlage (1) nach einem der vorangehenden Ansprüche, **dadurch gekennzeichnet, dass** das Dichtelement (24) als dünnes Plättchen mit einer Dicke im Bereich von ca. 5$\mu$m-15$\mu$m ausgebildet ist.

8. Projektionsbelichtungsanlage (1) nach einem der vorangehenden Ansprüche, **dadurch gekennzeichnet, dass** das Dichtelement (22) Edelstahl enthält bzw. aus Edelstahl gebildet ist.

9. Projektionsbelichtungsanlage (1) nach einem der vorangehenden Ansprüche, **dadurch gekennzeichnet, dass** das Dichtelement (22) im Bereich des Spaltes (23) eine wellenförmige Struktur (28) aufweist.

10. Projektionsbelichtungsanlage (1) nach einem der vorangehenden Ansprüche, **dadurch gekennzeichnet, dass** das Dichtelement (22) Quarz enthält bzw. aus Quarz gebildet ist.

11. Projektionsbelichtungsanlage (1) nach einem der vorangehenden Ansprüche, **dadurch gekennzeichnet, dass** das optische Element (21) und/oder das Strukturelement (25) und/oder der Spalt (23) in der Weise ausgebildet sind, dass bei Abwesenheit des Dichtelementes (22) eine Leaky-Seal-Dichtung realisiert ist.

12. Projektionsbelichtungsanlage (1) nach einem der vorangehenden Ansprüche, **dadurch gekennzeichnet, dass** es sich bei dem optischen Element (21) um eine planparallele Platte handelt.

13. Projektionsbelichtungsanlage (1) nach einem der vorangehenden Ansprüche 1-11, **dadurch gekennzeichnet, dass** es sich bei dem optischen Element (21) um ein nicht planes optisches Element, insbesondere um eine Linse, handelt.

14. Projektionsbelichtungsanlage (1) nach Anspruch 13, **dadurch gekennzeichnet, dass** das optische Element (21) in dem von dem Dichtelement (22) bedeckten Bereich im Wesentlichen plan ausgebildet ist.

15. Projektionsbelichtungsanlage (1) nach einem der vorangehenden Ansprüche, **dadurch gekennzeichnet, dass** zwischen der Flüssigkeitsschicht (24) und einem optisch aktiven Bereich (33) des optischen Elementes Mittel (30, 31) angeordnet sind, die einem Kriechen der Flüssigkeit in Richtung des optisch aktiven Bereiches (33) entgegenwirken.

16. Projektionsbelichtungsanlage (1) nach Anspruch 15, **dadurch gekennzeichnet, dass** es sich bei den Mitteln (30, 31) um eine Nut (30) in der Oberfläche des optischen Elementes oder um einen Wall (31) handelt.

17. Projektionsbelichtungsanlage (1) nach einem der vorangehenden Ansprüche, **dadurch gekennzeichnet, dass** im Bereich der Flüssigkeitsschicht (24) in dem optischen Element (21) bzw. in dem Strukturelement (25) mindestens ein Hohlraum (32) zur Aufnahme eines Flüssigkeitsvorrates vorhanden ist.

18. Projektionsbelichtungsanlage (1) nach einem der vorangehenden Ansprüche, **dadurch gekennzeichnet, dass** der Spalt (23) zwischen dem Strukturelement (25) und dem optischen Element (21) eine Dicke im Bereich von 0,1mm-0,5mm, vorzugsweise im Bereich von 0,2mm-0,4mm aufweist.

19. Projektionsbelichtungsanlage (1) nach einem der vorangehenden Ansprüche, **dadurch gekennzeichnet, dass** das optische Element (21) an drei Lagerpunkten (26) in der Weise gelagert ist, dass keine Momente in das optische Element (21) eingeleitet werden.

20. Projektionsbelichtungsanlage (1) nach einem der vorangehenden Ansprüche, **dadurch gekennzeichnet, dass** die Flüssigkeitsschicht (24) aus einer Flüssigkeit mit einer kinematischen Viskosität $v$ im Bereich von 300 - 3000 $mm^2$/s gebildet ist.

<u>Fig. 1</u>

Fig. 2

Fig. 3

Fig. 4

51

25

100

21

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2006069755 A2